# EUROPEAN PATENT APPLICATION

(11) **EP 2 680 681 A1**
(43) Date of publication of application: **01.01.2014**
(21) Application number: 12749826.9
(22) Date of filing: 22.02.2012
(51) Int. Cl.: H05K 5/02

(54) **ELECTRONIC DEVICE**

(30) Priority: 23.02.2011 JP 2011036620
(71) Applicant: NEC CASIO Mobile Communications, Ltd., Kawasaki-shi Kanagawa 211-8666 (JP); NEC Accesstechnica, LTD., Shizuoka 436-8501 (JP); NTT DOCOMO, Inc., Chiyoda-ku Tokyo 100-6150 (JP)
(72) Inventor: NODA, Youtarou, Kawasaki-shi, Kanagawa 211-8666 (JP); SHIRAISHI, Mitsutaka, Kawasaki-shi, Kanagawa 211-8666 (JP); HOMMA, Yasuyuki, Kakegawa-shi, Shizuoka 436-8501 (JP); YANO, Eiji, Tokyo 100-6150 (JP); NAGATA, Ryuuji, Tokyo 100-6150 (JP); SUGISAKI, Haruhiko, Tokyo 100-6150 (JP)
(74) Representative: Vossius & Partner
(86) International application number: PCT/JP2012/054281
(87) International publication number: WO 2012/115152

(57) **Abstract**

An electronic apparatus aimed to reduce cost, size and thickness is provided. The electronic apparatus includes a flexible circuit, a component mounted on the flexible circuit and a casing having an opening for accommodating the component. The flexible circuit is exposed from the opening when the component is not mounted in position. The flexible circuit includes, in the opening, a planar area on which the component is mounted. The component may, for example, be a battery or a nameplate.

## Description

### TECHNICAL FIELD

### [Cross-Reference to Related Application]

The present application is based upon and claims the benefit of the priority of JP Patent Application 2011-036620 filed in Japan on February 23, 2011, whose entire disclosure is to be incorporated herein by reference thereto.
This invention relates to an electrical apparatus, more particularly a mobile electrical apparatus, having a plurality of flexible circuits.

### BACKGROUND

An electronic apparatus, such as a mobile electronic apparatus, employs a flexible circuit (see e.g., Patent Literatures 1 and 2).

In a display apparatus, shown in Patent Literature 1, a flexible printed circuit board for backlight is stacked on a flexible printed circuit board for a panel.

A circuit module, shown in Patent Literature 2, includes a multi-chip module in which a plurality of semiconductor elements are mounted at high density on a wiring board, and a circuit board to which this multi-chip module is electrically connected. The circuit board has a through-hole extending through the circuit board in a direction of its thickness, and accommodates the wiring borad within the through-hole. The circuit board and the wiring board are electrically connected to each other by a plurality of flexible and flat-shaped flexible printed circuits.

### CITATIONS LIST

### PATENT LITERATURES

Patent Literature 1: JP Patent Kokai JP2006-154401A
Patent Literature 2: JP Patent Kokai JP10-189867A

### SUMMARY

### TECHNICAL PROBLEM

The disclosures of the above mentioned Patent Literatures are to be incorporated herein by reference. The following analysis is given from the perspective of the present invention.

In mobile electrical apparatus, batteries, inclusive of rechargeable batteries, are usually dismountable. As the functions of the electronic apparatus are diversified, the capacity required of the battery is increased, with the battery size increasing correspondingly. On the other hand, the size of the mobile electronic apparatus tends to become smaller. Inter alia, in the mobile electronic apparatus, carrying a touch panel thereon, it is necessary to increase the planar size of the apparatus, with the consequence that the apparatus size decreases in its thickness. Hence, the battery size also increases in the planar direction, while decreasing in the direction of its thickness. In such case, an area of an inner part of the electronic apparatus, exposed to outside when the battery is dismounted, also increases. If a component part to shield the inner part from outside is provided, the size along the thickness of the apparatus is increased.

In the display apparatus, shown in Patent Literature 1, a plurality of the flexible circuits are provided in a stacked state. In this case, the size of the apparatus along its thickness is increased. On the other hand, if a plurality of the flexible circuits, which differ in size, are stacked together, as in Patent Literature 1, and a battery or a nameplate, for example, is placed thereon, there is created a dead space in an area of the larger one of the flexible circuits on which the smaller flexible circuit(s) is not superposed. In addition, it is not possible to get the battery or the nameplate mounted in stability.

In the circuit module disclosed in Patent Literature 2, in which it is necessary to protect packaged components, the battery or the nameplate may not be directly mounted on the module carrying semiconductor devices or the like packaged thereon. Thus, in mounting a battery or the like on the circuit module, it is necessary to separately provide a protective element so that the packaged components are not contacted with the battery or the like, or so that the circuit module is not exposed. However, if the protective element is provided, the electronic apparatus is necessarily increased in size.

### SOLUTION TO PROBLEM

In a first aspect of the present invention, there is provided an electronic apparatus including a flexible circuit(s), a component(s) mounted on the flexible circuit(s) and a casing having an opening(s) for accommodating the component(s). The flexible circuit(s) is exposed from the opening(s) in a state where the component(s) is not mounted in position.

### ADVANTAGEOUS EFFECT OF THE INVENTION

The present invention has at least one of the following advantageous effects.

According to the present invention, a flexible circuit(s) is used as a base for a component(s), and the component(s) is used as a blind. In this manner, it becomes unnecessary to use a separate component(s) just for the base or for blinding, thus reducing the cost and the thickness as well as the size. Moreover, since it is unnecessary to set the flexible circuit(s) so as to clear the site where the component is set, it is possible to raise the degree of freedom in the designing of flexible circuit(s).

### BRIEF EXPLANATION OF THE DRAWINGS

Fig.1 is a schematic plan view showing inside of an electronic apparatus according to a first exemplary embodiment of the present invention.
Fig.2 is a schematic plan view showing inside of an electronic apparatus according to a first exemplary embodiment of the present invention.
Fig.3 is a schematic plan view showing inside of an electronic apparatus according to the first exemplary embodiment of the present invention.
Fig.4 is a schematic plan view showing inside of an electronic apparatus according to the first exemplary embodiment of the present invention.
Fig.5 is a schematic plan view showing inside of an electronic apparatus according to a second exemplary embodiment of the present invention.

### MODES FOR CARRYING OUT THE INVENTION

Preferred modes of the above mentioned first aspect will now be set out.

In a preferred mode of the first aspect, the flexible circuit has, in the opening, a planar area on which the component is mounted.

In a preferred mode of the first aspect, the electronic apparatus has a plurality of the flexible circuits. The flexible circuits are not superposed together within the opening.

In a preferred mode of the first aspect, the component covers not less than one-half of the area of the flexible circuit(s) exposed from the opening.

In a preferred mode of the first aspect, the flexible circuit(s) covers not less than one half of the area of the opening.

In a preferred mode of the first aspect, the area of the flexible circuit(s) is greater than a minimum necessary area.

In a preferred mode of the first aspect, the component is dismountable.

In a preferred mode of the first aspect, the component is at least one of a battery and a nameplate.

In a preferred mode of the first aspect, the nameplate is mounted on the flexible circuit(s), and the battery is mounted on the nameplate.

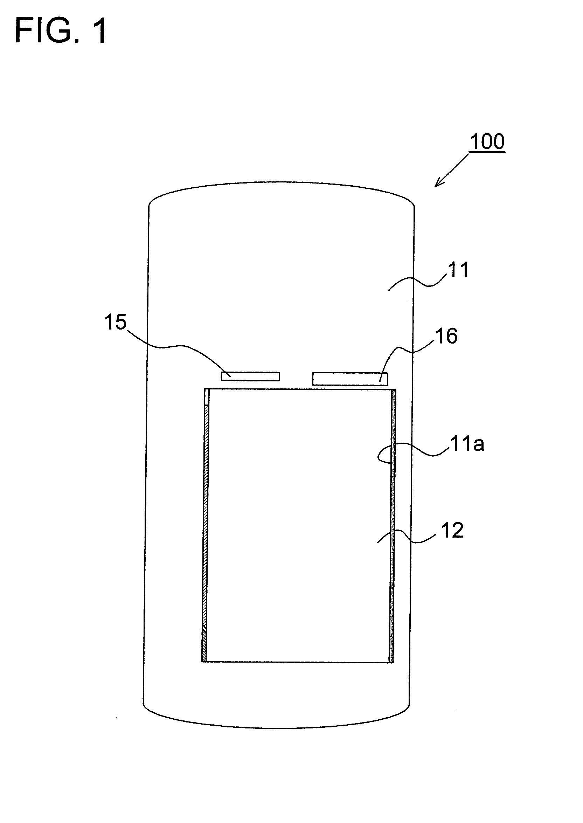

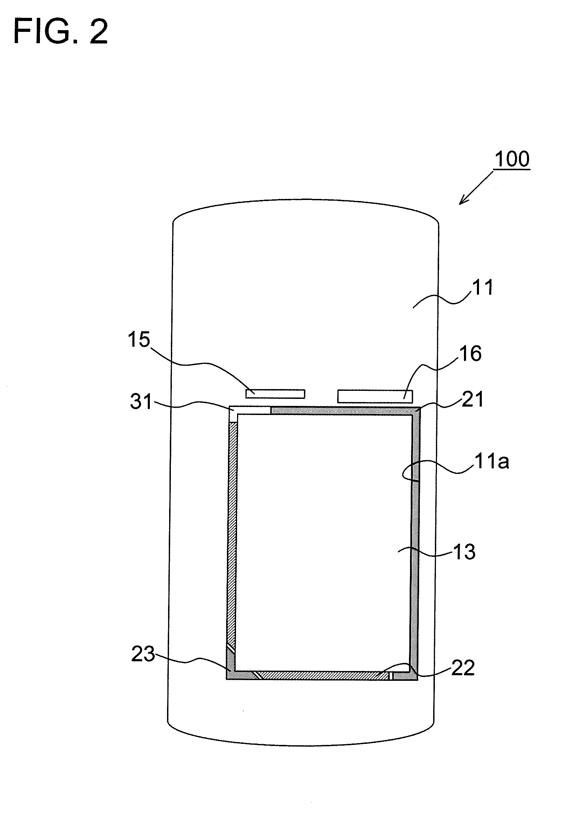

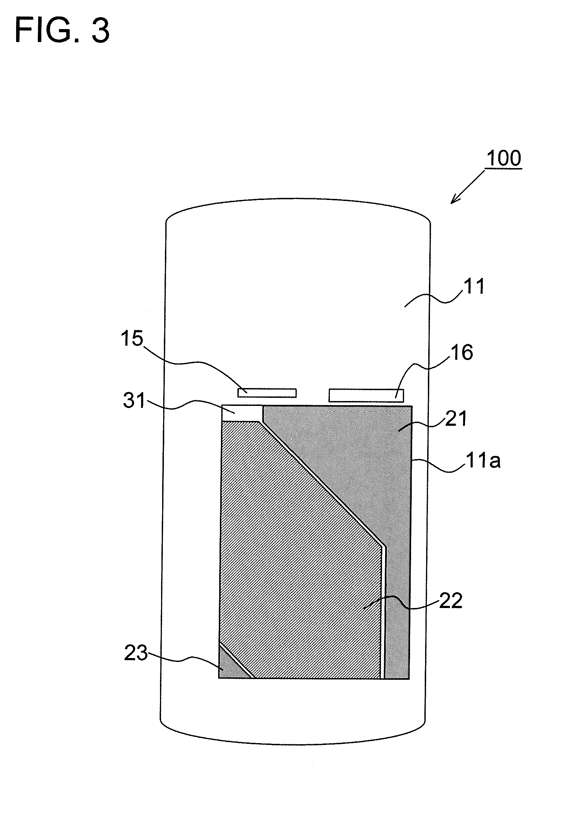

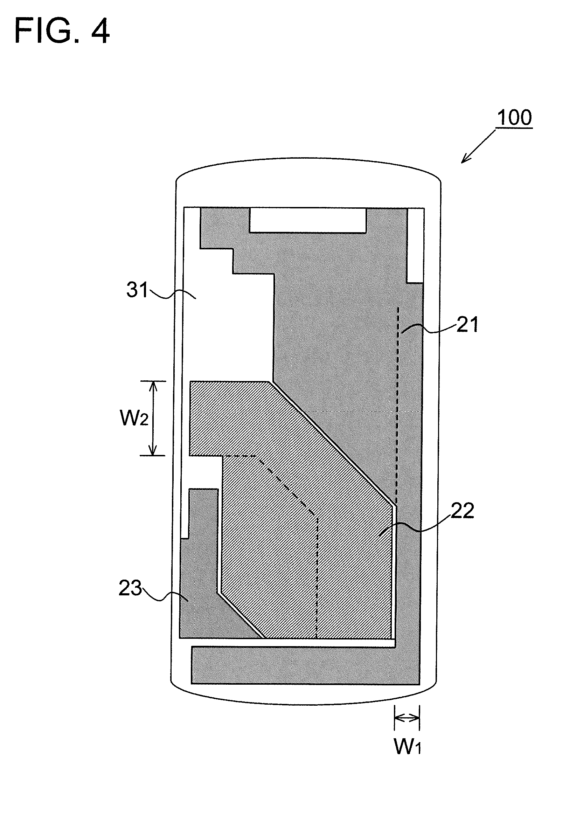

An electronic apparatus according to a first exemplary embodiment will now be detailed. In the following explanation, a mobile terminal apparatus, e.g., a mobile phone having a touch panel, is taken as an example. Fig.1 to Fig.4 depict schematic plan views showing inside of the electronic apparatus according to the first exemplary embodiment of the present invention. Fig.1 depicts a schematic plan view showing the electronic apparatus with a cover removed. Fig.2 depicts a schematic plan view showing the electronic apparatus of Fig.1 with a battery 12 removed. Fig.3 depicts a schematic plan view showing the electronic apparatus of Fig.2 with a nameplate 13 removed. Fig.4 depicts a schematic plan view showing the electronic apparatus of Fig.3 with a casing 11 removed. In Fig.1 to Fig.4, hatching is given to first to third flexible circuits 21 to 23 in order to make easy to recognize areas of the flexible circuits.

An electronic apparatus 100 includes a casing 11, a component(s), a memory card 15, a SIM (Subscriber Identity Module) card 16, first to third flexible circuits 21 to 23, a sheet metal 31 and a cover, not shown, which covers an opening 11a provided in the casing 11. The casing 11 has the opening 11a to accommodate the component(s). Preferably, the component(s) is exposable to outside, needs to be located so as to allow visual recognition by a user, or is dismountable. Also preferably, the component(s) is indispensable for the electronic apparatus 100. In the following explanation, the components are a battery 12, inclusive of a rechargeable battery, and a nameplate 13 by way of examples. In Fig.1 to Fig.3, a memory card 15 and a SIM card are connected to the electronic apparatus 100 and are partially exposed to outside.

In the mode shown in Figs.1 and.2, the battery 12 and the nameplate 13 are components mounted on the first to third flexible circuits 21 to 23. The battery 12 is accommodated in the opening 11a and electrically connected to a board, not shown. The battery 12 is disposed on the nameplate 13. The battery 12 may also be directly mounted on the first to third flexible circuits 21 to 23. Preferably, the battery 12 and the nameplate 13 are sheet-shaped or flat-plate-shaped to render it possible to screen the first to third flexible circuits 21 to 23.

In the mode shown in Fig.2, the nameplate 13 is mounted on the first to third flexible circuits 21 to 23 and in the opening 11a of the casing 11. The nameplate 13 herein means a thin sheet-like element which bears a product number of the electronic apparatus 100, manufacturer's name, remarks and the like and which is provided in a location that may be visually recognized by a user. For example, for the mobile phone, the disposition of the nameplate is made compulsory. In the mode shown in Fig.2, the nameplate 13 is formed so as to take up most of the area of the opening 11a. To enable the battery 12 to be mounted in stability, the size of the nameplate 13 (the area taken up by the nameplate in the opening 11a) is preferably not less than 50 percent, more preferably not less than 70 percent, further preferably not less than 80 percent, of the area of the opening 11a. If the area occupied by the nameplate 13 in the opening 11a is small such that the battery 12 may not be mounted in stability, a spacer which has the same thickness as the nameplate 13 may be mounted in an area of the opening 11a other than its area taken up by the nameplate 13 so that the nameplate 13 and the spacer form a planar area to mount the battery 12. Even if the spacer is provided, the thickness of the electronic apparatus 100 does not become greater because a thickness for disposing the nameplate 13 is inherently necessary in the electronic apparatus.

In the present exemplary embodiment, although the battery 12 and the nameplate 13 are mounted on the first to third flexible circuits 21 to 23, other component(s) may be mounted thereon. From the perspective of maintaining good appearance, the component(s) mounted on the first to third flexible circuits 21 to 23 may be preferably exposable to outside. The component(s) mounted on the first to third flexible circuits 21 to 23 may be also preferably exchangeable or detachable component(s).

The first to third flexible circuits 21 to 23 are covered with the battery 12 and the nameplate 13, and thus it is possible to reduce the area of the flexible circuits exposed from the opening 11a of the casing 11. It is thus preferred for the battery 12 and the nameplate 13 to cover not less than 50 percent, more preferably not less than 70 percent and further preferably not less than 90 percent of the area of the first to third flexible circuits 21 to 23 exposed from the opening 11a in a state that the battery 12 and the nameplate 13 are not mounted in position. By so doing, it is possible to prevent the appearance from becoming deteriorated due to the exposure of the first to third flexible circuits 21 to 23.

Also, to reduce the exposed area of the first to third flexible circuits when the cover is removed, the proportion of an area of the first to third flexible circuits 21 to 23 which is exposed from the opening 11a of the casing 11 in a state where at least one of the battery 12 and the nameplate 13 is set in position (viz., the proportion of the area of the first to third flexible circuits exposed in the state shown in Fig.1) is preferably not larger than 30 percent, more preferably not larger than 15 percent and further preferably not larger than 10 percent of the area of the opening 11a of the casing 11. By so doing, it becomes possible to reduce the area of the first to third flexible circuits 21 to 23 exposed in mounting or dismounting the battery 12, the memory card 15 or the SIM card 16 so as to prevent deterioration in appearance.

By covering the first to third flexible circuits 21 to 23 with the battery 12 or the nameplate 13, it becomes unnecessary to provide a separate component to screen the first to third flexible circuits 21 to 23. Viz., it is possible to reduce the number of components and to reduce the size as well as the thickness. Moreover, in designing the first to third flexible circuits 21 to 23, it becomes unnecessary to design the first ot third flexible circuits 21 to 23 to avoid (or go around) the opening 11a of the casing 11. Viz., it is possible to reduce the constraint on the designing of the first to third flexible circuits 21 to 23.

When the nameplate 13 is dismounted, the first to third flexible circuits 21 to 23 are exposed from the opening 11a of the casing 11. The first to third flexible circuits 21 to 23 are put on the sheet metal 31 and bent toward its reverse surface. The first to third flexible circuits 21 to 23 are then bonded to the sheet metal 31 by, for example, an electrically conductive adhesive or tape. This can improve electrical stability.

The first to third flexible circuits 21 to 23 are configured to be coplanar to one another. For example, the first to third flexible circuits 21 to 23 are of the same thickness and put on the sheet metal 31 so as not to become superposed one on another. This renders it possible to prevent the electronic apparatus 100 from becoming thick and to place the battery 12 and the nameplate 13 by forming the plane flush with one another. Inter alia, by forming the planar area, even a sheet-like component such as the nameplate 13 may be mounted in stability.

Preferably, in the opening 11a, the first to third flexible circuits 21 to 23 occupy an area which enables the battery 12 and the nameplate 13 to be mounted in stability. To put the battery 12 and the nameplate 13 on the first to third flexible circuits 21 to 23, the area of the opening 11a occupied by the first to third flexible circuits 21 to 23 is preferably not less than 50 percent, more preferably not less than 70 percent and further preferably not less than 80 percent of the total area of the opening 11a. In case the area occupied by the first to third flexible circuits 21 to 23 in the opening 11a is small such that it is not possible to get the battery 12 or the nameplate 13 mounted in stability, a spacer equivalent in thickness to the first to third flexible circuits 21 to 23 may be mounted in an area of the opening 11a other than an area occupied by the first to third flexible circuits 21 to 23, and a planar surface to put the battery 12 or the nameplate 13 may be formed by the spacer in conjunction with the first to third flexible circuits 21 to 23. Even if such spacer is provided, the thickness of the electronic apparatus 100 is not increased because the thickness for placing the first to third flexible circuits 21 to 23 is inherently necessary.

It is sufficient that the first to third flexible circuits 21 to 23 are of such shape as to allow the battery 12 or the nameplate 13 to be mounted in stability. The first to third flexible circuits 21 to 23 may thus be so shaped that, when the battery 12 or the nameplate 13 is mounted in position, the flexible circuits 21 to 23 are not exposed from the opening 11a of the casing 11. For example, the first to third flexible circuits 21 to 23 may be shaped so as to match to the shape or the size of the battery 12 or the nameplate 13. Moreover, to provide a planar surface on which the battery 12 and the nameplate 13 are mounted, the first to third flexible circuits 21 to 23 may be formed to have an area greater than the minimum area necessary to provide for electrical conduction, viz., an area to be occupied by wiring. For example, Assuming that the smallest necessary width of the first flexible circuit 21 is W₁ and that of the second flexible circuit 22 is W₂, the first flexible circuit 21 may be enlarged on the sheet metal 31 so as to have a width greater than the width W₁, and the second flexible circuit 22 may be enlarged on the sheet metal 31 so as to have a width greater than the width W₂. Inter alia, the first to third flexible circuits 21 to 23 are enlarged in area so as to cover the opening 11a of the casing 11. By enlarging the first to third flexible circuits 21 to 23 in area, electrical stability may be improved, at the same time as the bonding area is increased to raise physical strength. If the first to third flexible circuits 21 to 23 are shaped so that a combination of them is formed a planar surface, like a puzzle, position matching may be achieved with ease during the fabrication process.

In case where the electronic apparatus 100 is a touch panel type of a mobile phone, as an example, the first to third flexible circuits 21 to 23 may each be a flexible circuit electrically interconnecting a circuit and an antenna, a flexible circuit interconnecting a circuit and an LCD or a flexible circuit interconnecting a circuit and a touch panel.

According to the present invention, a dead space may be decreased to reduce the size as well as the thickness of the electronic apparatus.

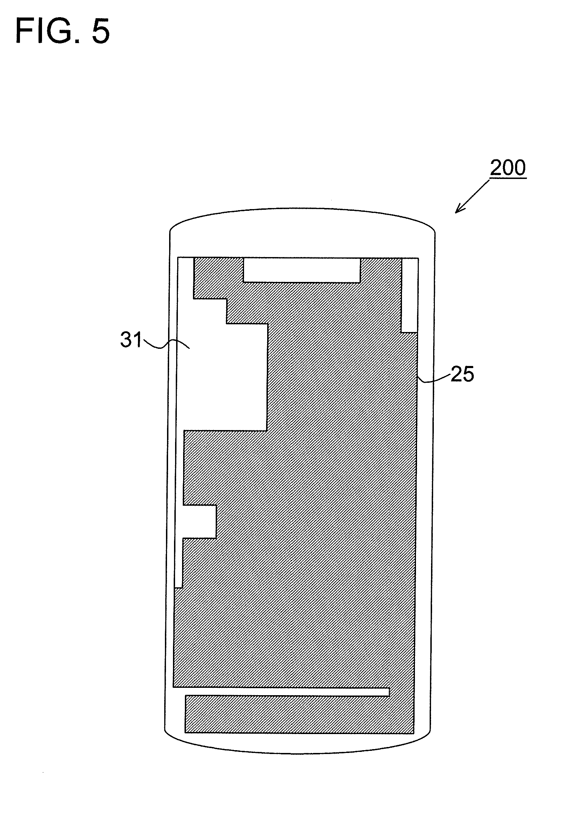

An electronic apparatus according to a second exemplary embodiment of the present invention will now be described. Fig.5 depicts a schematic plan view showing the inside of the electronic apparatus according to the second exemplary embodiment of the present invention. Fig.5 corresponds to Fig.4 according to the first exemplary embodiment. Although the first exemplary embodiment shows the mode having three flexible circuits, the number of the boards may be arbitrary. For example, as shown in Fig.5, a single flexible circuit 25 in which a plurality of terminals branch may be used. In such case, a plurality of flexible circuits may be united to provide the single flexible circuit 25 so as to occupy an area of the opening 11a of the casing 11 (to form a planar region for placing the battery or the nameplate). This may yield an advantageous effect comparable to that of the first exemplary embodiment.

Other modes in the second exemplary embodiment are the same as those of the first exemplary embodiment.

Although the electronic apparatus of the present invention is described based on the above exemplary embodiments, it is to be noted that the electronic apparatus of the present invention is not limited to the above exemplary embodiments and may include a wide variety of modifications, alterations and improvements, within the scope of the entire disclosure inclusive of the claims, based on the basic technical idea of the present invention. Within the scope of the claims, a wide variety of combinations, substitutions and selections of disclosed elements (including elements of the claims, exemplary embodiments and the drawings) may be possible.

Other problems, objects and developing modes of the present invention will become more apparent from the entire disclosure of the present invention inclusive of the claims.

### Industrial Applicability

The present invention has been described above with reference to a touch panel type of a mobile terminal apparatus, such as a mobile phone in which an input unit is unified to a display unit. However, an electronic apparatus to which the present invention may be applied is not limited to the above apparatus. For example, the present invention may be applied to advantage to a foldable mobile terminal apparatus, a slidable mobile terminal apparatus, a portable game machine, a portable audio apparatus and the like, inter alia, to a slim type of a mobile electronic apparatus.

### [Reference Signs List]

- 100, 200: electronic apparatus
- 11: casing
- 11a: opening
- 12: battery
- 13: nameplate
- 15: memory card
- 16: SIM card
- 21: first flexible circuit
- 22: second flexible circuit
- 23: third flexible circuit
- 25: flexible circuit
- 31: sheet metal

## Claims

1. An electronic apparatus, comprising:
a flexible circuit(s);
a component(s) mounted on the flexible circuit(s); and
a casing having an opening(s) for accommodating the component(s);
wherein the flexible circuit(s) is exposed from the opening in a state where the component is not provided in position.

2. The electronic apparatus according to claim 1, wherein
the flexible circuit includes, in the opening, a planar area on which the component is mounted.

3. The electronic apparatus according to claim 1 or 2, wherein
a plurality of the flexible circuits are provided;
the flexible circuits not being superposed together within the opening.

4. The electronic apparatus according to any one of claims 1 to 3, wherein
the component(s) covers not less than one-half of an area of the flexible circuit(s) exposed from the opening(s).

5. The electronic apparatus according to any one of claims 1 to 4, wherein
the flexible circuit(s) covers not less than one-half of the area of the opening(s).

6. The electronic apparatus according to any one of claims 1 to 5, wherein
the area of the flexible circuit(s) is greater than a minimum necessary area.

7. The electronic apparatus according to any one of claims 1 to 6, wherein
the component is dismountable.

8. The electronic apparatus according to any one of claims 1 to 7, wherein
the component is at least one of a battery and a nameplate.

9. The electronic apparatus according to claim 8, wherein
the nameplate is mounted on the flexible circuit(s);
the battery being mounted on the nameplate.
